**Europäisches Patentamt**

**European Patent Office**

**Office européen des brevets**

(19)

(11) Veröffentlichungsnummer: **0 259 934 B1**

## EUROPÄISCHE PATENTSCHRIFT

(12)

(45) Veröffentlichungstag der Patentschrift: **02.01.92**

(51) Int. Cl.⁵: **C23C 14/52**, C23C 14/54

(21) Anmeldenummer: **87201720.7**

(22) Anmeldetag: **09.09.87**

(54) **Kathodenzerstäubungseinrichtung mit einer Vorrichtung zur Messung eines kritischen Target-Abtrages.**

(30) Priorität: **10.09.86 DE 3630737**

(43) Veröffentlichungstag der Anmeldung:
**16.03.88 Patentblatt 88/11**

(45) Bekanntmachung des Hinweises auf die
Patenterteilung:
**02.01.92 Patentblatt 92/01**

(84) Benannte Vertragsstaaten:
**CH DE ES FR GB IT LI**

(56) Entgegenhaltungen:
**EP-A- 0 005 641**
**DD-A- 220 618**
**US-A- 4 379 040**
**US-A- 4 426 264**
**US-A- 4 545 882**

**PATENT ABSTRACTS OF JAPAN, unexami-ned applications, Field C, Band 7, Nr. 175, 3. August 1983 THE PATENT OFFICE JAPANESE GOVERNMENT Seite 92 C 179**

(73) Patentinhaber: **Philips and Du Pont Optical Deutschland GmbH**
**Podbielskistrasse 164**
**W-3000 Hannover 1(DE)**

(84) Benannte Vertragsstaaten:
**DE**

Patentinhaber: **Philips and Du Pont Optical Company**
**Buizerdlaan 2**
**NL-3435 SB Nieuwegein(NL)**

(84) Benannte Vertragsstaaten:
**CH ES FR GB IT LI**

(72) Erfinder: **Eggers, Gerhard, Dipl.-Ing.**
**Königsbergerstrasse 47**
**W-3004 Isernhagen 1(DE)**
Erfinder: **Langowski, Horst-Christian, Dipl.-Phys.**
**Kniestrasse 30**
**W-3000 Hannover 1(DE)**

(74) Vertreter: **Van Weele, Paul Johannes Frits et al**
**INTERNATIONAAL OCTROOIBUREAU B.V.**
**Prof. Holstlaan 6**
**NL-5656 AA Eindhoven(NL)**

## Beschreibung

Die Erfindung bezieht sich auf eine Kathodenzerstäubungseinrichtung zum Beschichten der Oberflächen von Gegenständen, in der eine Vakuum-Kammer vorgesehen ist, die ein Edelgas enthält, und in der eine Target-Kathode und eine Anode angeordnet sind, an die zur Erzeugung von Plasmaentladungen eine Spannung angelegt ist, wobei ein Magnetfeld, das die Plasmaentladungen intensiviert und auf den Bereich der Target-Kathode konzentriert, und eine Einrichtung zur Messung des Target-Abtrages vorgesehen sind.

In derartigen Kathodenzerstäubungseinrichtungen wird das Material der Target-Kathode abgetragen und schlägt sich unter anderem auch auf den Oberflächen der zu beschichtenden Gegenstände nieder. Aus diesem Grunde ist es wünschenswert, den Abtrag der Target-Kathode zu messen bzw. vor deren völligem Abtrag ein Alarmsignal zu erhalten. Ein völliger Abtrag der Target-Kathode ist nicht wünschenswert, da in diesem Falle deren Rückplatte bzw. Teile der Kathodenzerstäubungseinrichtung mitzerstäubt und beschädigt werden.

Es ist bei derartigen Anlagen bekannt, den Abtrag der Target-Kathode indirekt zu messen. Dies kann z.B. durch Messung der elektrischen Impedanz der Kathoden-Anodenanordnung, durch Messung der Target-Temperatur oder auch durch Messung der Veränderung des Magnetfeldes geschehen. So ist beispielsweise aus der DE-OS 34 25 659 ein Verfahren zum Regeln einer Sputter-Beschichtungseinrichtung bekannt, bei dem bestimmte Meßgrößen mit vorgegebenen Werten verglichen werden, um festzustellen, ob das Target so weit erodiert wurde, daß eine Verstellung der Plasma-Parameter erforderlich ist, oder das Target als verbraucht angesehen werden muß. Als Meßgrößen werden dabei eingestellte Arbeitspunkte für die Spannung und den Strom des Plasmas und für das magnetische Feld eingesetzt. Es wird hier also die Impedanz der Kathoden-Anodenanordnung bzw. eine Veränderung des Magnetfeldes gemessen. Ferner ist aus der DE-OS 34 25 344 eine Magnetron-Sputter-Beschichtungsquelle bekannt, bei der mittels einer in der Nähe der Target-Kathode vorgesehenen Hall-Sonde das Magnetfeld abgetastet wird. Aus der Änderung des Magnetfeldes werden Rückschlüsse auf den Target-Abtrag gezogen. Aus der DD-PS 220 618 ist eine Schaltungsanordnung zur Target-Verschleißbestimmung in Sputter-Anlagen bekannt, bei der eine Gleichspannungsmeßgröße eingesetzt wird, die abhängig ist von der vom Plasmatron aufgenommenen Leistung. Auf diese Weise kann über die aufgenommene Leistung des Plasmatrons ein Rückschluß auf den Abtrag der Target-Kathode gezogen werden. Allen diesen Verfahren ist jedoch gemeinsam, daß sie lediglich eine indirekte Messung ermöglichen und so keine präzise Messung des Abtrags der Target-Kathode liefern können. Außerdem liefern diese Verfahren gewissermaßen nur ein statistisches Mittel des Abtrages und lassen so keine Rückschlüsse darauf zu, ob das Material an einer Stelle möglicherweise schon völlig oder fast völlig abgetragen ist.

Aus der europäischen Patentanmeldung 0 046 154 ist es ferner bekannt, in einer Kathodenzerstäubungseinrichtung hinter der Target-Kathode eine abgeschlossene Kammer vorzusehen, welche mit einem unter Druck stehenden Gas gefüllt ist. Der Druck des Gases in der Kammer wird gemessen und bei einem Abfall des Druckes Alarm gegeben bzw. die Anlage abgeschaltet, da die Target-Kathode dann an wenigstens einer Stelle völlig abgetragen ist. Diese Anordnung hat jedoch den Nachteil, daß über den Abtrag des Targets erst dann eine Aussage gemacht werden kann, wenn dieser an wenigstens einer Stelle schon völlig abgetragen ist. Ein Einsatz dieses Verfahrens ist daher insbesondere in solchen Fällen nicht möglich, in denen es auf besondere Reinheit der Beschichtung ankommt. In diesen Fällen darf eine an der Target-Kathode im allgemeinen vorgesehenen Rückplatte nicht mitzerstäubt werden. Darüber hinaus erfordert die gasdichte Kammer einen sehr hohen konstruktiven Aufwand der Anlage.

Es ist Aufgabe der Erfindung, bei einer Kathodenzerstäubungseinrichtung der eingangs genannten Art eine Vorrichtung anzugeben, welche einen kritischen Abtrag des Materials der Target-Kathode zuverlässig bereits vor dem völligen Abtrag des Materials angibt und die darüber hinaus einfach zu verwirklichen ist.

Diese Aufgabe wird erfindungsgemäß dadurch gelöst, daß zur Messung eines kritischen Target-Abtrages in der Target-Kathode wenigstens eine Sonde vorgesehen ist, die bei bis auf die Sonde abgetragenem Target-Material anspricht.

In der Target-Kathode wird, beispielsweise in einer Bohrung oder Nut, eine Sonde eingebracht, welche signalisiert, daß das sie umgebende Target-Material auf wenigstens einer Seite völlig abgetragen ist. Die Sonde wird in der Target-Kathode in der Weise positioniert, daß sie sicher bereits vor dem völligen Abtrag des Materials anspricht. Die Sonde wird also im allgemeinen im Bereich der Rückwand der Target-Kathode angebracht werden. Wird die Sonde an einer Stelle angebracht, die bevorzugt einem Abtrag ausgesetzt ist, so kann auf diese Weise mit einfachen Mitteln vor Erreichen eines völligen Abtrages der Target-Kathode an einer beliebigen Stelle ein Alarmsignal erhalten werden, welches angibt, daß die Target-Kathode kurz vor ihrem völligen Abtrag steht. Dies ist von besonderer Bedeutung, da jede Stillstandszeit einer Kathodenzerstäubungseinrichtung unwirtschaftlich ist. Die Einrichtung nach der Erfindung bietet so die Möglichkeit, unnötige Stillstandszeiten zu vermeiden. Gleichzeitig ist das Risiko eines völligen Abtrages der Target-Kathode beseitigt, was insbesondere bei hohen Anforderungen an die Reinheit der Beschichtung der zu beschichtenden Oberflächen von Bedeutung ist.

Nach einer weiteren Ausgestaltung der Erfindung ist vorgesehen, daß die Sonde ein unter Druck stehendes Gas enthält, dessen Druckabfall den kritischen Targetabtrag markiert.

Die Sonde zur Markierung des kritischen Target-Abtrages kann beispielsweise aus einem Rohr bestehen, welches ein unter Druck stehendes Gas enthält. Der Druck dieses Gases wird registriert. Ein Druckabfall des Gases signalisiert sofort, daß die Sonde undicht geworden ist durch das Abtragen des sie umgebenden Materials der Target-Kathode und das damit verbundene Undichtwerden.

Nach einer weiteren Ausgestaltung der Erfindung ist vorgesehen, daß in der Sonde eine Kammer vorgesehen ist, die über eine druckdichte Schlauchverbindung mit einem Druckschalter verbunden ist, und daß die Kammer und der Schlauch mit einem Gas gefüllt sind, so daß der Druckschalter bei einem Druckabfall des Gases in Folge Erreichen des kritischen Target-Abtrages anspricht.

Die Messung des Drucks des in der Sonde befindlichen Gases kann auf diese Weise mit einfachsten Mitteln vorgenommen werden. Bei einem Ansprechen des Druckschalters kann ein Alarmsignal gegeben werden; es kann aber auch die Kathodenzerstäubungseinrichtung unmittelbar abgeschaltet werden.

Nach einer weiteren Ausgestaltung der Erfindung ist vorgesehen, daß in der Target-Kathode eine Bohrung vorgesehen ist, die über eine druckdichte Schlauchverbindung mit einem Druckschalter verbunden ist und daß die Bohrung und der Schlauch mit einem unter Druck stehenden Gas gefüllt sind, so daß der Druckschalter bei einem Druckabfall des Gases in Folge des Erreichens des kritischen Target-Abtrages anspricht.

Die Sonde kann im einfachsten Falle aus einer einfachen Bohrung in der Target-Kathode bestehen, welche über eine druckdichte Schlauchverbindung mit einem Druckschalter verbunden ist. Ist das die Bohrung umgebende Material der Target-Kathode an einer Stelle abgetragen, entweicht das Gas und der Druckschalter spricht an. Auf diese Weise ist bei einfachstem konstruktiven Aufwand dennoch ein sicheres Messen eines kritischen Target-Abtrages möglich.

Nach einer weiteren Ausgestaltung der Erfindung ist vorgesehen, daß die Sonde eine elektrisch leitfähige Meßleitung aufweist, deren Kontakt mit dem Entladungsplasma elektronisch ausgewertet wird.

Neben der Möglichkeit der Messung des Druckes eines in der Sonde vorgesehenen Gases besteht auch die Möglichkeit, in der Sonde eine elektrisch leitfähige Meßleitung vorzusehen, deren Kontakt mit dem Entladungsplasma infolge des Erreichens des kritischen Target-Abtrages elektronisch ausgewertet wird. In diesem Falle ist es nur noch erforderlich, die Meßleitung mit einer im allgemeinen außerhalb der Kammer angeordneten Auswerteelektronik zu verbinden. Die Auswertung des elektrischen Potentials der Meßleitung kann auf folgende Art und Weise vorgenommen werden. Bei Erreichen des kritischen Target-Abtrages, d. h. also, wenn das Target-Material bis auf die Sonde abgetragen ist, strömt das Entladungsplasma in die Meßsonde ein und umgibt auch die Meßleitung. Die Ionen des Plasmas sind positiv geladen und beeinflussen das elektrische Potential der Meßleitung entsprechend. Diese Veränderung des Potentials der Meßleitung wird durch die Auswerte-Elektronik erkannt, die daraufhin ein entsprechendes Signal gibt.

Noch einer weiteren Ausgestaltung der Erfindung ist vorgesehen, daß die Meßleitung in einem Keramikrohr verläuft, das wiederum mit einem Metallrohr ummantelt ist, und daß beide Rohre in einem Teilbereich zu einer Seite hin geöffnet sind, so daß die Meßleitung in diesem Bereich zum abzutragenden Target-Material freiliegt.

Es hat sich als vorteilhaft erwiesen, die Meßleitung in einem Keramikrohr anzuordnen, da dieses elektrisch isolierend wirkt. Das Keramikrohr ist wiederum von einem Metallrohr umgeben. Beide Rohre sind in einem Teilbereich zu der abzutragenden Seite der Target-Kathode hin geöffnet. Ist das Material der Target-Kathode bis auf diesen Bereich abgetragen, so gerät die Meßleitung in elektrischen Kontakt mit dem Entladungsplasma, was, wie oben beschrieben, elektronisch ausgewertet werden kann.

Nach einer weiteren Ausgestaltung der Erfindung ist vorgesehen, daß die Sonde in dem Bereich der Target-Elektrode angeordnet ist, der am schnellsten abgetragen wird. Im allgemeinen ist der am schnellsten abgetragene Bereich der Target-Elektrode empirisch bekannt. In diesen Fällen bereitet es keine Probleme, eine oder mehrere Sonden in diesen Bereichen vorzusehen.

Nach einer weiteren Ausgestaltung der Erfindung ist vorgesehen, daß das Magnetfeld der Kathodenzerstäubungseinrichtung in einem definierten Bereich der TargetKathode stärker ist als in den übrigen Bereichen und daß die Sonde in diesem definierten Bereich angeordnet ist.

Ist kein genau definierter Bereich der Target-Kathode bekannt, der bevorzugt abgetragen wird, oder existiert kein solcher, so besteht die Möglichkeit, das Magnetfeld in einem bestimmten Bereich stärker vorzusehen als in den übrigen Bereichen. Dies hat zur Folge, daß das Material der Target-Kathode in diesem Bereich stärker als in den übrigen abgetragen wird. Die Sonde zur Messung des kritischen Target-Abtrages wird dann in diesem Bereich angebracht und gibt ein Erreichen des kritischen Target-Abtrages in diesem Bereich an, der in jedem Falle eher erreicht ist als in den übrigen Bereichen der Target-Kathode.

Nach einer weiteren Ausgestaltung der Erfindung ist vorgesehen, daß die aus dem abzutragenden Metall bestehende Target-Kathode mit einer aus einem anderen Metall bestehenden Rückplatte versehen ist und daß die Sonde in dem abzutragenden Metall in einem Grenzbereich zur Rückplatte angeordnet ist.

Im allgemeinen weist die aus dem abzutragenden Material bestehende Target-Kathode eine Rückplatte auf, die ebenfalls aus einem Metall besteht. In diesen Fällen ist es vorteilhaft, die Sonde in den Grenzbereichen zwischen den beiden Metallen vorzusehen. Dies wird im allgemeinen in der Weise geschehen, daß in dem abzutragenden Metall in einem zu der Rückplatte benachbarten Grenzbereich eine Bohrung vorgenommen wird, in die die Sonde eingeführt wird.

Die Erfindung wird nachstehend anhand einiger Ausführungsbeispiele näher erläutert. Es zeigen:

Fig. 1     eine Kathodenzerstäubungseinrichtung zum Beschichten der Oberflächen von Gegenständen in teilweiser Schnittdarstellung,

Fig. 2     eine Target-Kathode der Einrichtung nach Fig. 1 in Draufsicht,

Fig. 3     eine erste Ausführungsform einer Sonde in einer Target-Kathode in Schnittdarstellung,

Fig. 4     eine zweite Ausführungsform einer Sonde in Schnittdarstellung,

Fig. 5     den Schnitt durch eine Target-Kathode mit eingesetzter Sonde nach Fig. 4.

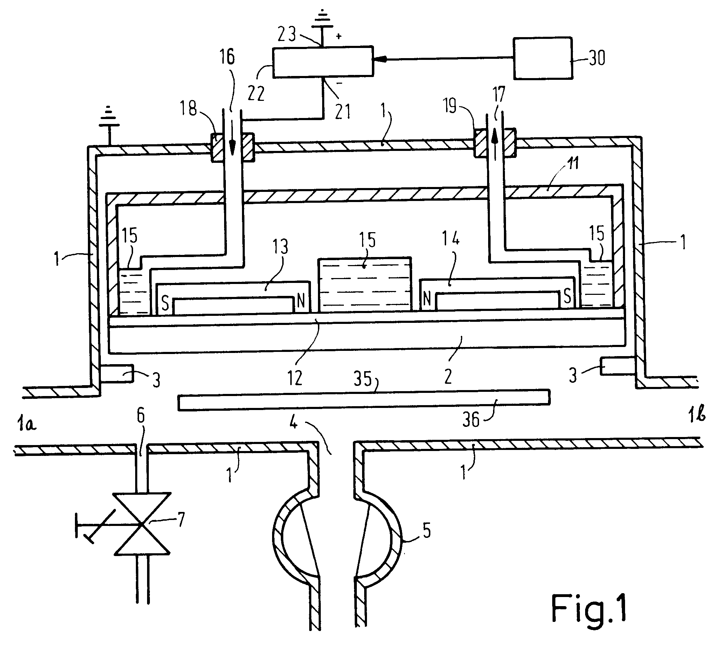

Eine in Fig. 1 im Schnitt dargestellte Kathodenzerstäubungseinrichtung zum Beschichten der Oberflächen von Gegenständen weist eine Vakuumkammer 1 auf, in der eine Target-Kathode 2 und eine Anode 3 angeordnet sind. Die Vakuumkammer 1 ist rundherum luftdicht abgeschlossen und mittels einer mit einer Öffnung 4 verbundenen Pumpe 5 von Luft evakuierbar. Uber eine zweite Öffnung 6 wird der Kammer 1 über ein Dosierventil 7 von außen Edelgas zugeführt Die Kammer weist zwei Öffnungen 1a und 1b auf, die nach außen führen und durch die in in der Figur nicht dargestellter Weise in die Kammer zu beschichtende Gegenstände hereingeführt werden und durch die die Gegenstände nach dem Beschichten wieder herausgeführt werden. Die Öffnungen 1a und 1b münden in rohrförmige Ausläufer, die in der in der Figur nicht dargestellter Weise ebenso wie auch die Kammer 1 selbst gegenüber der äußeren Atmosphäre luftdicht abgeschlossen sind. Die Anode 3 verläuft ringförmig in der Vakuumkammer 1, während die Kathode 2 an einer in einem oberen Bereich der Kammer 1 vorgesehen elektrisch leitfähigen Halterung 11 im Inneren der Kammer angeordnet ist. Die Target-Kathode 2 ist dazu über eine Rückplatte 12 mit der Halterung 11 verbunden. In der Halterung 11 sind oberhalb der Rückplatte 12 der Target-Kathode 2 zwei Anordnungen 13 und 14 zur Erzeugung eines Magnetfeldes vorgesehen. Die Magnetfelder weisen mit ihren Nord- bzw. Südpolen zu der Rückplatte 12 und verlaufen in Teilbereichen der Target-Kathode in etwa parallel zu dieser. Zwischen den Magnet-Anordnungen 13 und 14 sind in der Halterung 11 Kühlkanäle 15 vorgesehen, welche von einer Kihlflüssigkeit durchströmt werden. Die Kühlflüssigkeit wird den Kanälen über ein Rohr 16 zu- und ein Rohr 17 abgeführt. Die Rohre 16 und 17 sind durch Dichtungen 18 und 19 aus der Kammer 1 herausgeführt. Wenigstens die Dichtung 18 ist so ausgeführt, daß sie zwischen dem Rohr 16 und der Wand der Kammer 1 elektrisch isolierend wirkt. Ferner ist wenigstens das Rohr 16, gewünschtenfalls auch das Rohr 17, elektrisch leitfähig ausgeführt.

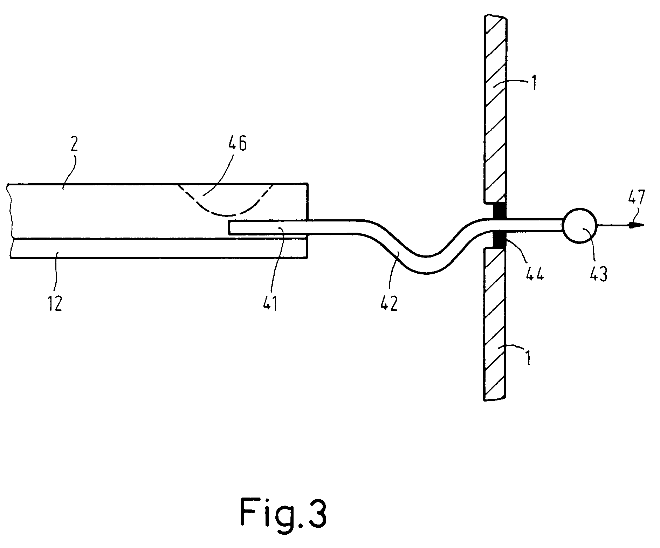

Die Kathode 2 ist über die Rückplatte 12 und das Rohr 16, das über wenigstens einen der Kühlkanäle 15 elektrisch leitend mit der Rückplatte 12 verbunden ist, mit einem negativen Pol 21 einer Spannungsquelle 22 verbunden. Ein positiver Pol 23 der Spannungsquelle 22 ist mit Masse verbunden. Die in der Kammer 1 angeordnete Anode 3 ist ebenfalls mit Masse verbunden. Die Spannungsquelle 22 kann von einer Auswerteeinheit 30 angesteuert werden, welche in in der Figur nicht dargestellter Weise von einer Sonde Meßsignale erhält. Die nähere Funktionsbeschreibung der Auswerteelektronik 30 und der in der Figur nicht dargestellten Sonde wird anhand der Fig. 3 bis 5 vorgenommen werden.

Die Funktion der in Fig. 1 dargestellten Kathodenzerstäubungseinrichtung ist folgende:
Mittels der Spannungsquelle 22 ist an die Target-Kathode 2 eine gegenüber der Anode 3 positive Spannung angelegt. Die Target-Kathode und die Anode befinden sich in der mit einem Edelgas gefüllten Vakuumkammer 1. Bei Anlegen einer geeigneten Spannung finden zwischen diesen beiden Elektroden Plasmaentladungen des Edelgases statt. Mittels der Magnet-Anordnungen 13 und 14 werden diese Plasmaentladungen auf den Bereich der Target-Kathode konzentriert. Die positiven Ionen des Gases treffen dadurch verstärkt auf die Oberfläche der Target-Kathode 2 und lösen aus ihr Teilchen des Metalles, aus dem sie besteht, heraus. Diese Metallteilchen schlagen sich auf einer Oberfläche 35 eines in der Fig. 1 im Schnitt dargestellten flächenhaften Gegenstandes 36 nieder. Auf diese Weise wird die Oberfläche 35 des Gegenstandes 36 mit einer dünnen Schicht beschichtet, die aus dem Material der Target-Kathode 2 besteht. Die Parameter zur Einstellung der Intensität der Plasmaentladungen sind der Gasdruck, die zwischen die Elektroden angelegte Spannung und gegebenenfalls die Stärke des Magnetfeldes.

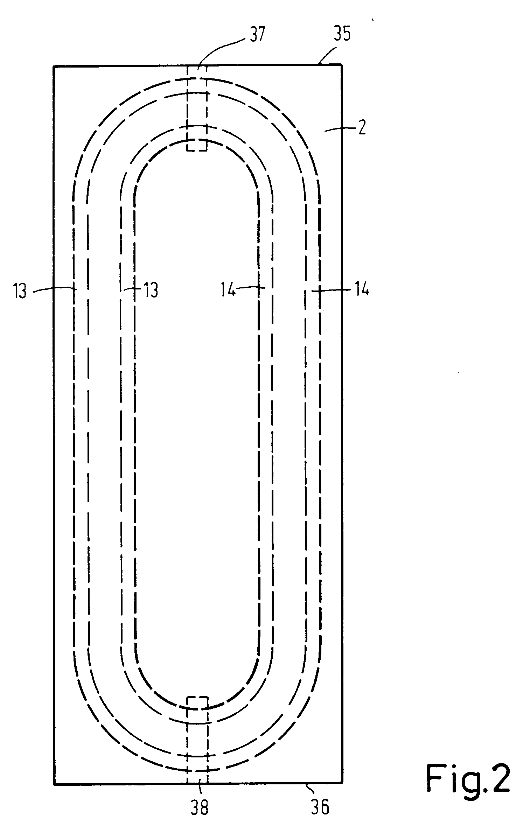

In Fig. 2 ist die Target-Elektrode 2 nach Fig. 1 in Draufsicht von der Anodenseite her dargestellt. Die Target-Kathode 2 hat in diesem Ausführungsbeispiel eine in etwa rechteckige Form. In der Draufsicht-Darstellung von Fig. 2 sind ebenfalls die Magnetfeld-Anordnungen 13 und 14 schematisch dargestellt. Diese Magnetfeld-Anordnungen verlaufen in Form eines Ovals. In dem in Fig. 2 dargestellten Beispiel verlaufen die Magnetfeldanordnungen in den Kopfbereichen 35 und 36 der Target-Kathode in einem relativ kleinen Radius, so daß sich in diesen Bereichen ein relativ starkes Magnetfeld ausbildet. Aus diesem Grunde wird das Material der Target-Kathode in diesen Bereichen relativ stark abgetragen. Es ist daher sinnvoll, eine Sonde zur Messung eines kritischen Target-Abtrages in einem oder in beiden dieser Bereiche anzuordnen. In der Figur sind zwei mögliche Anbringungsorte 37 und 38 solcher Sonden schematisch dargestellt. Im folgenden werden anhand der Fig. 3 bis 5 zwei Ausführungsbeispiele solcher Sonden näher erläutert, wie sie beispielsweise in einer Kathodenzerstäubungseinrichtung nach Fig. 1 bzw. einer Target-Kathode nach Fig. 1 und 2 eingesetzt werden können. Diese Sonden dienen dazu, beim Erreichen eines kritischen Target-Abtrages ein entsprechendes Signal an die in Fig. 1 schematisch dargestellte Auswerteeinheit 30 zu geben, welche wiederum die Spannungsquelle 22 ansteuert und damit die an die Elektroden angelegte Spannung rechtzeitig vor einem völligen Abtrag der Target-Kathode 2 abschaltet.

In Fig. 3 ist als erstes Ausführungsbeispiel eine Sonde zur Messung eines kritischen Target-Abtrages zusammen mit einer Target-Kathode im Schnitt dargestellt. Die Target-Kathode 2, die beispielsweise der in Fig. 1 und Fig. 2 dargestellten Bauart sein kann, trägt an ihrer Rückseite eine Rückplatte 12. Die Target-Kathode selbst kann beispielsweise aus Aluminium und die Rückplatte beispielsweise aus Kupfer bestehen. In die in Fig. 3 dargestellte Target-Kathode 2 ist in einem Bereich nahe der Rückwand 12 eine Bohrung 41 eingebracht. Diese Bohrung ist über einen flexiblen, jedoch gasdichten und elektrisch isolierenden Schlauch 42 mit einem Drucksensor 43 verbunden. Der Schlauch 42 ist durch eine Dichtung 44 geführt. Die Dichtung 44 ist ihrerseits in einer Wand der Kammer einer Kathodenzerstäubungseinrichtung verbunden, die beispielsweise die in Fig. 1 dargestellte Kammer 1 sein kann. Sowohl die Bohrung 41 in der Target-Kathode wie auch der Schlauch 42 sind mit einem Gas gefüllt. Dieser Gasdruck wird von dem Drucksensor 43 gemessen. In der Target-Kathode 2 ist in der Figur beispielhaft ein möglicher Abtrag 46 eingetragen. Erreicht dieser Abtrag 46 die Bohrung 41, so entweicht das in der Bohrung 41 und dem Schlauch 42 unter Druck stehende Gas durch diese entstandene Öffnung. Infolgedessen fällt der Druck in dem System ab, was durch den Drucksensor 43 gemeldet wird. Dies kann z.B. in der Weise geschehen, daß der Drucksensor 43 ein elektrisches Signal an eine in Fig. 1 schematisch dargestellte Auswerteelektronik 30 leitet, die wiederum die an die Elektroden 3 und 2 angelegte Spannung unterbricht.

Anstelle der in der Fig. 3 eingebrachten Bohrung 41 kann auch in eine solche Bohrung eine Sonde eingesteckt werden, welche wiederum über einen Schlauch mit dem Drucksensor verbunden ist und die eine Kammer aufweist, die mit einem Gas gefüllt ist. Dabei muß die Sonde dann aus dem gleichen Material bestehen wie die Target-Kathode.

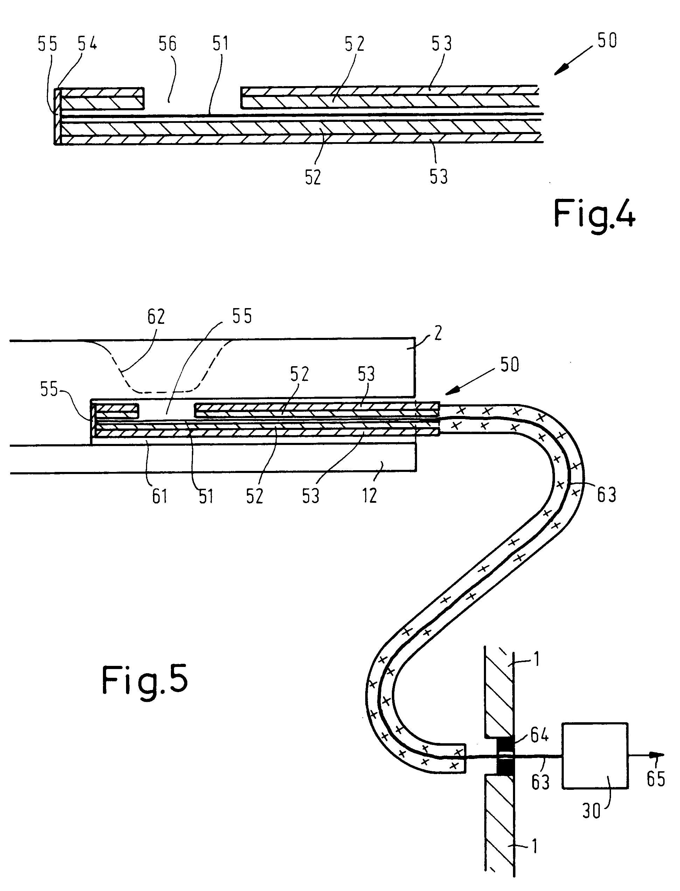

In Fig. 4 ist eine zweite Ausführungsform einer Sonde zur Messung eines kritischen Target-Abtrages im Schnitt dargestellt. Bei dieser Ausführungsform handelt es sich um eine elektrisch arbeitende Sonde 50 . Im Innern der Sonde 50 ist eine Meßleitung 51 angeordnet. Die Meßleitung 51 ist mit einem Keramikrohr 52 und dieses wiederum mit einem Metallrohr 53 umgeben. An ihrem ersten Ende 54, das zuerst in eine Bohrung bzw. Nut einer in der Fig. 4 nicht dargestellten Target-Kathode eingeführt wird, sind die Meßleitung 51, das Keramikrohr 52 und das Metallrohr 53 mit einem elektrisch isolierenden Deckel 55 abgeschlossen. Dieser Deckel 55 kann beispielsweise mit Keramikkleber verklebt sein. Das Keramikrohr 52 und das Metallrohr 53 sind in einem halbzylinderförmigen Bereich 56 offen. Dieser Bereich 56 zeigt im eingebauten Zustand zu der Seite der Target-Kathode hin, die abgetragen wird.

Dies ist in Fig. 5 näher dargestellt, in der die in Fig. 4 dargestellte auf elektrische Weise arbeitende Sonde und eine Target-Kathode, die beispielsweise die in den Fig. 1 und 2 dargestellte Target-Kathode 2 sein kann, im Schnitt dargestellt sind. Die Sonde 50 ist dabei in eine Bohrung 61 der Target-Kathode 2 eingeführt. Die Bohrung 61 ist in einem Bereich angebracht, der an die Rückplatte 12 angrenzt. In der Target-Kathode 2 ist in der Fig. 5 beispielhaft ein möglicher Abtrag 62 eingezeichnet. Dieser Abtrag 62 ist in der Figur kurz vor dem Durchbruch zur Sonde dargestellt. Die Meßleitung 51 in der Sonde ist über ein isoliertes Kabel 63 mit einer Auswerteelektronik verbunden, die beispielsweise die in Fig. 1 dargestellte Auswerteelektronik 30 sein kann. Dabei ist das Kabel durch eine isolierte Durchführung 64 geführt. Diese isolierte Durchführung 64 befindet sich beispielsweise in einer Wand der in Fig. 1 dargestellten Vakuumkammer 1. Die Meßleitung 51 der Sonde 50 ist also über die Kabelverbindung 63 mit der Auswerteelektronik 30 verbunden. Die Auswerte-Elektronik 30 mißt, auf welchem elektrischen Potential die Meßleitung 51 liegt. Sobald der in der Figur schematisch dargestellte Abtrag 62 den offenen Bereich 55 der Sonde erreicht, erhält die Meßleitung Kontakt mit dem positiv geladenen Entladungsplasma. Dies wird von der Auswerteelektronik 30 in Folge eines sich ändernden elektrischen Potentials der über die Kabelverbindung 63 mit der Auswerte-Elektronik 30 verbundenen Meßleitung 51 registriert, und es wird ein entsprechendes Signal 65 nach außen gegeben, das beispielsweise dazu dienen kann, die Spannungszuführung zu den Elektroden der Kathodenzerstäubungseinrichtung zu unterbrechen.

Neben dem in Fig. 5 dargestellten Beispiel sind weitere elektronisch arbeitende Ausführungen einer solchen Sonde möglich. Es könnte beispielsweise sich bei der Meßleitung auch um einen Widerstandsdraht handeln, der seinen Abschlußwiderstand gegenüber der Meßelektronik 30 verändert, sobald er durchschmilzt.

**Patentansprüche**

1.  Kathodenzerstäubungseinrichtung zum Beschichten der Oberflächen von Gegenständen, in der eine Vakuum-Kammer vorgesehen ist, die ein Edelgas enthält und in der eine Target-Kathode und eine Anode angeordnet sind, an die zur Erzeugung von Plasmaentladungen eine Spannung angelegt ist, wobei ein Magnetfeld, das die Plasmaentladungen intensiviert und auf den Bereich der Target-Kathode konzentriert, und eine Einrichtung zur Messung des Target-Abtrages vorgesehen sind, dadurch gekennzeichnet, daß zur Messung eines kritischen Target-Abtrages in der Target-Kathode wenigstens eine Sonde vorgesehen ist, die bei bis auf die Sonde abgetragenem Target-Material anspricht.

2.  Kathodenzerstäubungseinrichtung nach Anspruch 1, dadurch gekennzeichnet, daß die Sonde ein Gas enthält, dessen Druckabfall den kritischen Target-Abtrag markiert.

3.  Kathodenzerstäubungseinrichtung nach Anspruch 2, dadurch gekennzeichnet, daß in der Sonde eine Kammer vorgesehen ist, die über eine druckdichte Schlauchverbindung mit einem Druckschalter verbunden ist, und daß die Kammer und der Schlauch mit einem Gas gefüllt sind, so daß der Druckschalter bei einem Druckabfall des Gases in Folge des Erreichens des kritischen Target-Abtrages anspricht.

4.  Kathodenzerstäubungseinrichtung nach Anspruch 2 oder 3, dadurch gekennzeichnet, daß das Material der Sonde das gleiche wie das verwendete Targetmaterial ist.

5.  Kathodenzerstäubungseinrichtung nach Anspruch 2, dadurch gekennzeichnet, daß die Sonde aus einem Teil der Target-Kathode selbst besteht, worin eine Bohrung vorgesehen ist, die über eine druckdichte Schlauchverbindung mit einem Druckschalter verbunden ist und daß die Bohrung und der Schlauch mit einem Gas gefüllt sind, so daß der Druckschalter bei einem Druckabfall des Gases in Folge Erreichen des kritischen Target-Abtrages anspricht.

6.  Kathodenzerstäubungseinrichtung nach Anspruch 1, dadurch gekennzeichnet, daß die Sonde eine elektrisch leitfähige Meßleitung aufweist, deren Kontakt mit dem Entladungsplasma elektronisch ausgewertet wird.

7.  Kathodenzerstäubungseinrichtung nach Anspruch 6, dadurch gekennzeichnet, daß die Meßleitung in einem Keramikrohr verläuft, das wiederum mit einem Metallrohr ummantelt ist, und daß beide Rohre in einem Teilbereich zu einer Seite hin geöffnet sind, so daß die Meßleitung in diesem Bereich zum abzutragenden Target-Material freiliegt.

8.  Kathodenzerstäubungseinrichtung nach einem oder mehreren der Ansprüche 1 bis 7, dadurch gekennzeichnet, daß die Sonde im Bereich der Target-Elektrode angeordnet ist, der am schnellsten abgetragen wird.

9.  Kathodenzerstäubungseinrichtung nach Ansprüche 1 bis 7, dadurch gekennzeichnet, daß das Magnetfeld der Kathodenzerstäubungseinrichtung in einem definierten Bereich der Target-Kathode stärker ist als in den übrigen Bereichen und daß die Sonde in diesem definierten Bereich angeordnet ist.

10. Kathodenzerstäubungseinrichtung nach Ansprüche 1 bis 9, dadurch gekennzeichnet, daß die aus dem abzutragenden Metall bestehende Target-Kathode mit einer aus einem anderen Metall bestehenden Rückplatte versehen ist und daß die Sonde in dem abzutragenden Metall in einem Grenzbereich zur Rückplatte angeordnet ist.

11. Kathodenzerstäubungseinrichtung nach Anspruch 10, dadurch gekennzeichnet, daß das abzutragende Metall Aluminium ist und daß die Rückplatte aus Kupfer besteht.

## Claims

1. A cathode-sputtering apparatus for coating surfaces of objects, having a vacuum chamber which contains an inert gas and in which a target cathode and an anode are arranged to which a voltage is applied to produce plasma discharges, a magnetic field, which intensifies the plasma discharges and concentrates them at the area of the target cathode, and a device for measuring the target consumption being provided, characterized in that for measuring a critical target consumption at least one probe is provided in the target cathode, which probe responds when the target material has eroded up to the probe.

2. A cathode-sputtering apparatus as claimed in Claim 1, characterized in that the probe contains a gas, whose drop in pressure marks the critical target consumption.

3. A cathode-sputtering apparatus as claimed in Claim 2, characterized in that the probe has a chamber, which is connected to a pressure switch via a pressure-tight tube connection, and in that the chamber and the tube are filled with a gas, so that the pressure switch is actuated in the case of a drop in gas pressure as a result of the critical target consumption being reached.

4. A cathode-sputtering apparatus as claimed in Claim 2 or 3, characterized in that the material of the probe is the same as the material used for the target.

5. A cathode-sputtering apparatus as claimed in Claim 2, characterized in that the probe comprises a part of the target cathode itself formed with a bore, which bore is connected to a pressure switch via a pressure-tight tube connection, and in that the bore and the tube are filled with a gas, so that the pressure switch is actuated in the case of a drop in gas pressure as a result of the critical target consumption being reached.

6. A cathode-sputtering apparatus as claimed in Claim 1, characterized in that the probe comprises an electrically conductive measurement lead whose contact with the discharge plasma is detected electronically.

7. A cathode-sputtering apparatus as claimed in Claim 6, characterized in that the measurement lead is arranged in a ceramic tube surrounded by a metal tube, and in that both tubes are locally open to one side, so that at this location the measurement lead borders on the target material to be removed.

8. A cathode-sputtering apparatus as claimed in any one of the Claims 1 to 7, characterized in that the probe is arranged at the location with the highest rate of consumption of the target electrode.

9. A cathode-sputtering apparatus as claimed in any one of the Claims 1 to 7, characterized in that in a specific area of the target cathode the magnetic field of the cathode-sputtering apparatus is stronger than in the other areas, and in that the probe is arranged in said specific area.

10. A cathode-sputtering apparatus as claimed in any one of the Claims 1 to 9, characterized in that the target cathode, which is made of the metal to be deposited, is provided with a rear plate of another metal, and in that the probe is arranged in an area bordering on the rear plate in the metal to be deposited.

11. A cathode-sputtering apparatus as claimed in Claim 10, characterized in that the metal to be deposited is aluminium, and in that the rear plate is made of copper.

## Revendications

1. Dispositif de pulvérisation cathodique destiné à recouvrir d'une couche les surfaces d'objets, dispositif dans lequel est prévue une chambre à vide contenant un gaz rare et dans lequel sont disposées une cathode cible et une anode auxquelles est appliquée une tension pour engendrer des décharges de plasma, dispositif dans lequel sont prévus en outre un champ magnétique intensifiant les décharges de plasma et concentré sur la zone de la cathode cible ainsi qu'un dispositif de mesure de l'ablation de la cible, caractérisé en ce qu'au moins une sonde est prévue dans la cathode cible pour mesurer une ablation critique de la cible, sonde qui réagit lorsque le matériau de la cible a été enlevé par ablation jusqu'à la sonde.

2. Dispositif de pulvérisation cathodique selon la revendication 1, caractérisé en ce que la sonde contient un gaz dont la chute de pression indique l'ablation critique de la cible.

3. Dispositif de pulvérisation cathodique selon la revendication 2, caractérisé en ce que, dans la sonde, est prévue une chambre qui est reliée à un interrupteur à pression par une liaison par tuyau flexible étanche à la pression, et en ce que la chambre et le tuyau flexible sont remplis d'un gaz, de sorte que l'interrupteur à pression réagit à une chute de la pression du gaz due au fait que l'ablation critique de la cible a été atteinte.

4. Dispositif de pulvérisation cathodique selon la revendication 2 ou 3, caractérisé en ce que le matériau de la sonde est identique au matériau de la cible utilisé.

5. Dispositif de pulvérisation cathodique selon la revendication 2, caractérisé en ce que la sonde est constituée d'une partie de la cathode cible elle-même dans laquelle est prévu un alésage relié à un interrupteur à pression par une liaison par tuyau flexible étanche à la pression et en ce que l'alésage et le tuyau flexible sont remplis d'un gaz de sorte que l'interrupteur à pression réagit à une chute de pression du gaz après que l'ablation critique de la cible a été atteinte.

6. Dispositif de pulvérisation cathodique selon la revendication 1, caractérisé en ce que la sonde présente un conducteur de mesure électriquement conducteur relié à l'appareil de mesure dont le contact avec le plasma de décharge est detecté par voie électronique.

7. Dispositif de pulvérisation cathodique selon la revendication 6, caractérisé en ce que le conducteur de mesure s'étend dans un tube céramique, enveloppé à son tour d'un tube métallique, et en ce que, dans une zone partielle, les deux tubes sont ouverts d'un côté, de sorte que, dans cette zone, le conducteur de mesure est exposé au matériau de cible devant être enlevé par ablation.

8. Dispositif de pulvérisation cathodique selon l'une quelconque des revendications 1 à 7, caractérisé en ce que la sonde est disposée dans la zone de l'électrode cible qui est enlevée le plus rapidement par par ablation.

9. Dispositif de pulvérisation cathodique selon la revendication 1 à 7, caractérisé en ce que le champ magnétique du dispositif de pulvérisation cathodique a une plus grande intensité dans une zone définie de la cathode cible que dans les autres zones et en ce que la sonde est disposée dans cette zone définie.

10. Dispositif de pulvérisation cathodique selon les revendications 1 à 9, caractérisé en ce que la cathode cible constituée du métal devant être enlevé par ablation est pourvue d'une plaque arrière constituée d'un autre métal et en ce que la sonde située dans le métal devant être enlevé par ablation est disposée dans une zone contiguë à la plaque arrière.

11. Dispositif de pulvérisation cathodique selon la revendication 10, caractérisé en ce que le métal devant être enlevé par ablation est de l'aluminium et en ce que la plaque arrière est constituée de cuivre.

Fig.1

Fig.2

Fig.3

11

Fig.4

Fig.5